(19) Europäisches Patentamt
European Patent Office
Office européen des brevets

(11) **EP 2 820 733 B1**

(12) **FASCICULE DE BREVET EUROPEEN**

(45) Date de publication et mention de la délivrance du brevet:
**17.05.2023   Bulletin 2023/20**

(21) Numéro de dépôt: **13712871.6**

(22) Date de dépôt: **28.02.2013**

(51) Classification Internationale des Brevets (IPC):
**G01R 15/18** *(2006.01)*   **G01R 27/18** *(2006.01)*
**B60L 53/00** *(2019.01)*   **B60L 53/14** *(2019.01)*
**B60L 3/00** *(2019.01)*   **H02H 3/16** *(2006.01)*

(52) Classification Coopérative des Brevets (CPC):
**B60L 53/00; B60L 3/0069; B60L 3/0092; B60L 53/14; H02H 3/162;** G01R 15/185; G01R 27/18; Y02T 10/70; Y02T 10/7072; Y02T 90/14

(86) Numéro de dépôt international:
**PCT/FR2013/050416**

(87) Numéro de publication internationale:
**WO 2013/128128 (06.09.2013 Gazette 2013/36)**

(54) **DETECTION D'UN COURANT DE FUITE COMPRENANT UNE COMPOSANTE CONTINUE DANS UN VEHICULE**

FESTSTELLEN VON LECKSTRÖMEN MIT GLEICHSTROMANTEIL IN EINEM FAHRZEUG

DETECTING DC COMPONENT LEAKAGE CURRENT IN A VEHICLE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.02.2012   FR 1251824**

(43) Date de publication de la demande:
**07.01.2015   Bulletin 2015/02**

(73) Titulaire: **Valeo eAutomotive France SAS 95800 Cergy (FR)**

(72) Inventeurs:
• **BOUCHEZ, Boris**
  **F-95800 Cergy (FR)**
• **SARDAT, Pierre**
  **F-93340 Le Raincy (FR)**

(74) Mandataire: **Valeo Powertrain Systems Service Propriété Intellectuelle Immeuble le Delta 14, avenue des Béguines 95892 Cergy Pontoise (FR)**

(56) Documents cités:
EP-A1- 2 284 549        EP-A2- 2 384 922
WO-A1-2010/112251       WO-A1-2012/052366
WO-A2-2005/114805       WO-A2-2012/136336
DE-A1- 2 300 802        FR-A1- 2 752 059
FR-A1- 2 919 068        FR-A1- 2 921 769
US-A1- 2004 001 292

• **ROMAN M ET AL: "Low consumption Flux-gate transducer for AC and DC high-current measurement", POWER ELECTRONICS SPECIALISTS CONFERENCE, 2008. PESC 2008. IEEE, IEEE, PISCATAWAY, NJ, USA, 15 juin 2008 (2008-06-15), pages 535-540, XP031300027, ISBN: 978-1-4244-1667-7**

**Description**

La présente invention concerne un dispositif de détection d'un courant de fuite embarqué dans un véhicule. Elle concerne également un système de protection électrique de la charge d'une batterie embarquée dans le véhicule et un système de mesure d'une impédance de terre d'une installation domestique servant à la charge de ladite batterie, systèmes comprenant un tel dispositif de détection d'un courant de fuite.

Elle concerne encore un système de charge de ladite batterie comprenant un tel système de protection électrique et/ou un tel système de mesure d'impédance de terre. Elle concerne aussi un véhicule comportant un tel système de charge de la batterie.

Plus particulièrement, l'invention concerne le domaine des véhicules électriques ou hybrides. Dans de tels véhicules, un moteur électrique, généralement triphasé, sert ou tout du moins participe à l'entraînement du véhicule. Il est alimenté par une batterie qu'il est nécessaire de recharger périodiquement.

Il est connu de recharger la batterie à l'aide d'une installation fixe de fourniture de courant, tel qu'un circuit électrique domestique alimenté en courant alternatif. Le véhicule est relié à l'installation et un circuit embarqué dans le véhicule permet de recharger la batterie, notamment à l'aide d'un redresseur.

Le circuit électrique embarqué peut être à l'origine de courants de fuite, notamment par l'intermédiaire de composants parasites situés entre le circuit et le châssis du véhicule. De tels courants de fuite sont susceptibles de traverser une impédance placée entre le châssis et la terre, telle qu'une personne touchant la carrosserie du véhicule alors qu'elle a les pieds en contact avec le sol. On peut encore avoir le même problème si on touche la carrosserie d'une main, et un équipement métallique de l'habitation de l'autre main. Les conséquences d'un tel phénomène sur l'organisme sont plus ou moins sévères, pouvant aller de la simple sensation désagréable jusqu'à l'électrocution.

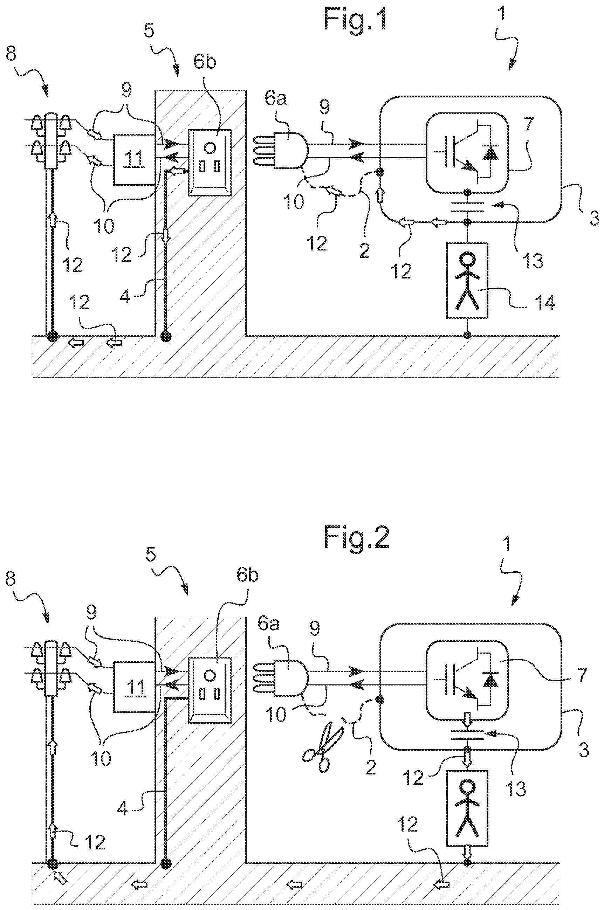

Comme illustré aux figures 1 à 3, il est connu pour limiter ce risque d'équiper le véhicule 1 d'un conducteur de terre 2 permettant de relier le châssis 3 du véhicule 1 à un câble 4 de mise à la terre d'une installation électrique domestique 5, par l'intermédiaire d'un connecteur électrique 6a, 6b.

A ces figures, une circulation de courant à travers un réseau électrique 8, l'installation électrique domestique 5 et un circuit électrique 7 du véhicule est illustré par des flèches 9, 10, ici dans une configuration phase/neutre. Un disjoncteur différentiel 11 est prévu entre le réseau d'alimentation 8 et l'installation électrique domestique 5. Il a pour fonction de détecter les courants de fuite et de couper l'alimentation en cas de danger.

A la figure 1, un courant de fuite, illustré par les flèches 12, est présent. Typiquement, le courant de fuite comprend une composante parasite prévue par conception qui est essentiellement alternative et une composante de défaut qui peut comprendre un signal alternatif et/ou continu. La composante de défaut correspond à un évènement non souhaité qui provoque un défaut d'isolement.

Le courant de fuite atteint le châssis 3 par l'intermédiaire d'une capacité parasite 13 ou des condensateurs utilisés à des fins de compatibilité électromagnétique. Le conducteur de terre 2 est ici opérationnel et le courant de fuite retourne préférentiellement du châssis 3 du véhicule vers l'installation domestique par ledit câble 4 de mise à la terre. Indépendamment du déclenchement du disjoncteur différentiel 11, les risques qu'une personne 14 venant en contact avec le châssis soit traversée par une partie du courant de fuite lui causant des dommages sont donc limités.

A la figure 2, le même courant de fuite est présent mais le conducteur de terre est défaillant. Il est ici sectionné. Dans cette hypothèse, le courant de fuite traverse la personne 14 au contact du châssis mais les conséquences d'une telle défaillance restent limitées si le disjoncteur différentiel 11 est opérationnel. En effet, celui-ci coupe l'alimentation si les seuils fixés pour son déclanchement sont atteints, typiquement 30 mA pour des courants alternatifs à 50 Hz pour le normes actuellement en vigueur. La personne 14 au contact du châssis 3 risque de percevoir la traversée du courant de fuite mais le déclenchement du disjoncteur opérationnel lui évitera tout dommage corporel sérieux.

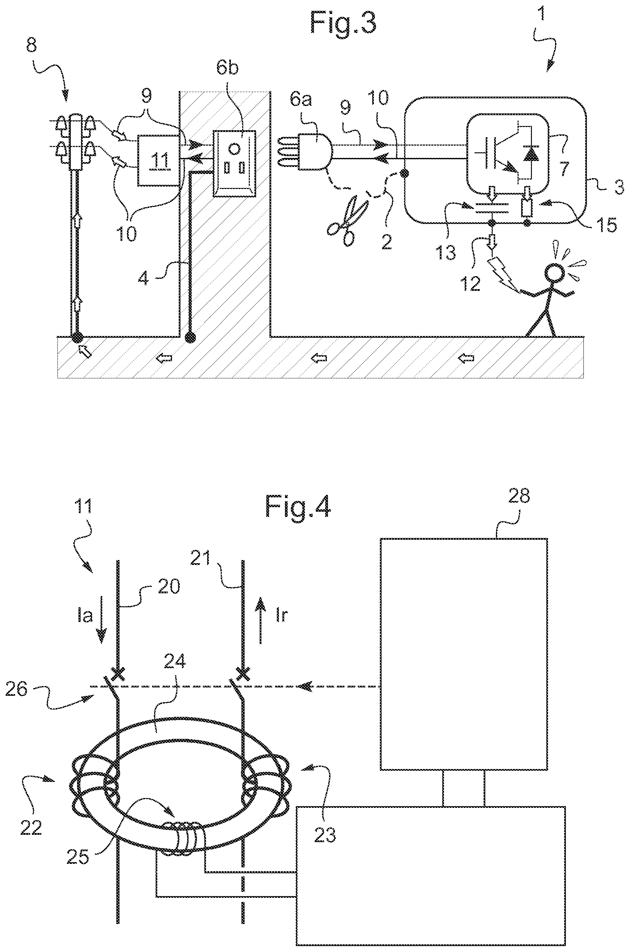

A la figure 3, un courant de fuite est toujours présent. Contrairement aux cas précédents où il était supposé de moyenne nulle, il présente cette fois une composante continue. Ledit courant de fuite atteint le châssis par l'intermédiaire de la capacité parasite 13 et d'une résistance parasite 15. La présence d'une composante continue est particulièrement dangereuse car elle rend défaillant la plupart des disjoncteurs différentiels 11 présents dans les installations électriques domestiques actuelles. Dans un tel cas, si le conducteur de terre 2 est lui aussi défaillant, les courants de fuite traversent la personne 14 au contact du châssis 3 sans qu'elle soit protégée par le disjoncteur différentiel 11 car ce dernier n'est plus en état de se déclencher. On peut alors aller jusqu'à l'électrocution.

En outre, la protection de l'intégralité de l'installation électrique domestique 5 est touchée. En effet, le disjoncteur différentiel 11 étant défaillant, un courant de fuite intervenant sur n'importe quel appareil électrique de l'installation ne sera plus en mesure d'être détecté. Tous les occupants de l'habitation normalement protégée par ledit disjoncteur différentiel 11 sont de la sorte mis en danger.

On explique en référence aux figures 4, 5 et 6 l'origine du problème rencontré avec les disjoncteurs différentiels évoqués plus haut en cas de présence d'une composante continue.

La figure 4 illustre de façon schématique ce type d'appareil. Les courants entrant la et sortant Ir de l'installation protégée traversent des enroulements 22, 23 prévus le long de conducteurs d'entrée/sortie, ici une phase 20 et un neutre 21. Lesdits enroulements 22, 23 sont disposés sur un même tore magnétique 24. Ils sont configurés pour générer des flux magnétiques de même intensité mais circulant dans le tore de façon opposée quand le courant passant par la phase 20 est de même intensité que le courant passant par le neutre 21. Un troisième enroulement 25 est disposé sur le tore. Il est relié à un dispositif de coupure 26 permettant de stopper l'alimentation en courant de l'installation protégée en cas de présence d'un courant dépassant certains seuils dans ledit troisième enroulement 25. Plus précisément, le troisième enroulement 25 est relié à un circuit 27 alimentant un électroaimant 28, prévu pour déclencher l'ouverture du dispositif de coupure 26 en fonction du courant circulant dans le circuit 27.

Tant que le courant circulant dans la phase 20 est identique au courant circulant dans le neutre 21, les flux induits par les enroulements 22, 23 dans le tore s'annulent en permanence et aucune variation de flux n'intervient dans le tore 24. Aucun courant n'est donc généré par le troisième enroulement 25 et l'alimentation de l'installation protégée est assurée.

Par contre, en cas de présence d'un courant de fuite, les courants circulant dans les conducteurs 20, 21 ne sont plus identiques et une variation de flux intervient dans le tore 24 qui provoque la circulation d'un courant dans le circuit 27. L'intensité du courant de fuite correspond à l'amplitude de la différence entre courant de phase et courant de neutre, cette dernière correspondant à une amplitude de variation de flux dans le tore et donc à une intensité de courant circulant dans le circuit 27, ce dernier actionnant ou non le dispositif de coupure 26 par l'intermédiaire de l'électro-aimant 28, en fonction de ladite intensité.

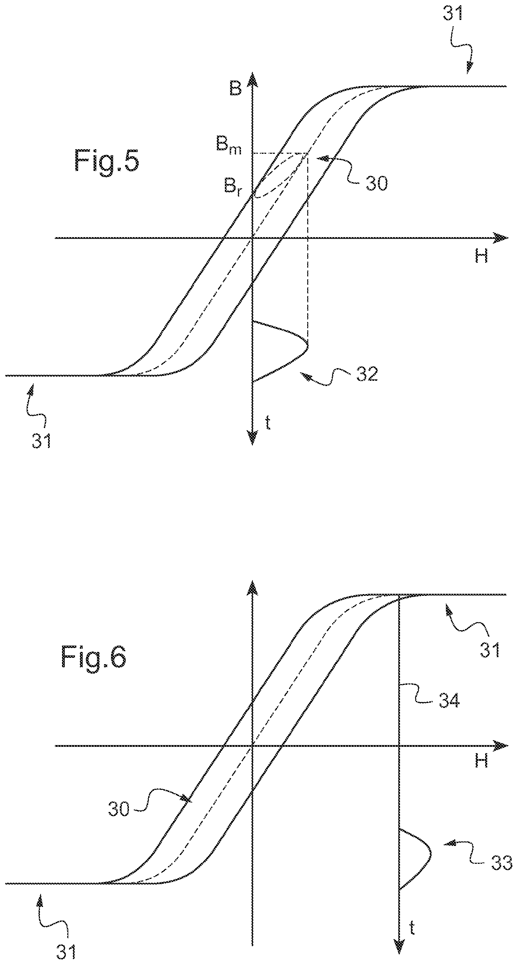

Les figures 5 et 6 illustrent l'effet de la présence d'une composante continue dans un courant de fuite sur la variation de flux générée par un tore magnétique tel que celui évoqué plus haut. A ces figures, on a représenté la courbe d'aimantation classique des matériaux constituant de tels tores. L'intensité H de l'excitation magnétique (mesurée en A/m ou Oersted) est donnée en abscisse et la densité B de flux magnétique (mesurée en Tesla ou Gauss) ou induction est illustrée en ordonnée. La courbe d'aimantation donne la valeur de l'induction générée en fonction de l'excitation magnétique, cette dernière étant fonction du courant traversant le conducteur générant le champ. De façon connue, les matériaux magnétiques employés présentent un cycle d'hystérésis 30 et surtout des zones de saturation 31 pour lesquelles une variation d'excitation magnétique correspond à une très faible variation de l'induction.

A la figure 5, on a représenté un profil 32 d'excitation magnétique correspondant aux effets d'un courant de fuite ici du type mono-alternance (l'axe des ordonnées sert pour cela d'axe du temps). Une telle excitation provoque une variation d'induction entre une valeur maximale Bm et une valeur Br correspondant à l'induction rémanente du matériau. Dans un tel cas, le courant de fuite provoque donc une variation de flux $\Delta B$ dans le tore magnétique et le disjoncteur différentiel peut fonctionner de façon nominale. Ici $\Delta B = Bn - Br$ est suffisamment grand pour permettre une détection.

A la figure 6, on a représenté un autre profil 33 d'excitation magnétique provoqué par un courant de fuite toujours du type mono-alternance mais comportant cette fois une composante continue (un axe 34 parallèle à l'axe des ordonnées sert comme axe du temps). En raison de ladite composante continue, l'excitation magnétique se trouve dans une zone pour laquelle le matériau sature et on constate que les variations d'excitation magnétique venant s'ajouter à la composante continue ne provoquent plus aucune variation, ou d'infimes variations d'induction. Ici $\Delta B = Bn - Br$ est trop faible pour permettre une détection. Dans un tel cas, la composante continue du courant, en faisant saturer le matériau magnétique, empêche toute variation de flux et rend donc défaillant le disjoncteur différentiel équipé dudit tore. Pour les matériaux magnétiques communément employés dans les disjoncteurs différentiels, on estime qu'un courant présentant une composante continue de plus de 6 mA n'est pas admissible selon les normes actuellement en vigueur.

Or les risques d'apparition d'une composante continue de plus forte intensité dans les courants provenant des circuits équipant les véhicules électriques ne sont pas négligeables, notamment en raison de la présence de convertisseurs élévateurs de tension, ayant notamment une fonction de correction de facteur de puissance (« Power Factor Correction (PFC) » en anglais), utilisés pour recharger la batterie.

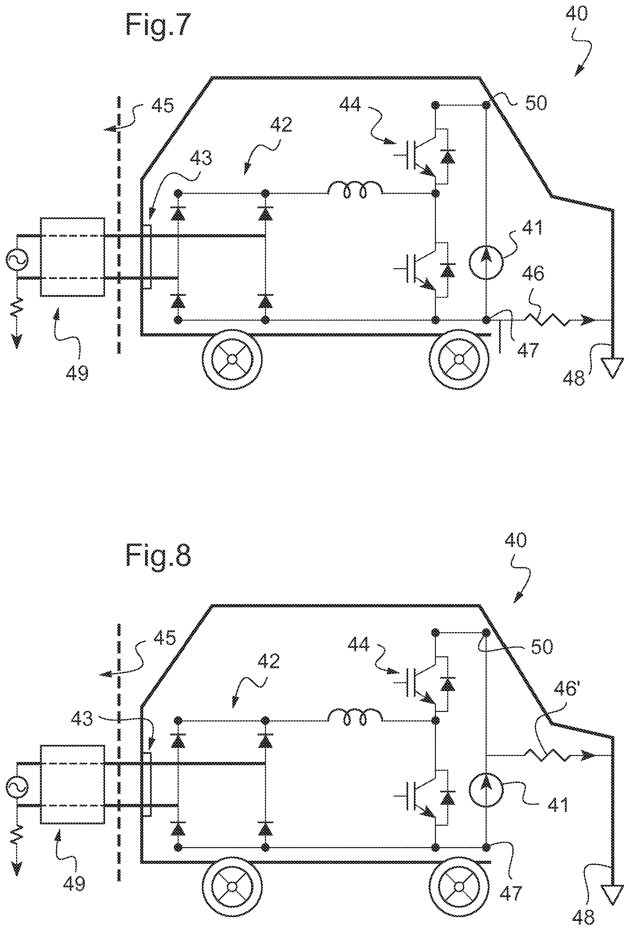

Un tel risque est détaillé aux figures 7 et 8 qui illustrent de façon schématique un véhicule 40 muni d'un circuit de charge d'une batterie 41 comprenant un pont redresseur 42, relié à un connecteur de charge 43, et un convertisseur 44, élévateur de tension et éventuellement correcteur de facteur de puissance. Le connecteur de charge 43 est destiné à être connecté à une installation électrique domestique 45 délivrant un courant alternatif, protégée par un disjoncteur différentiel 49. La présence d'un courant de fuite est représentée par une résistance de fuite 46, 46'.

A la figure 7, le courant de fuite circule entre la masse 47 du circuit et le châssis 48 du véhicule. Dans une telle hypothèse, le courant de fuite varie avec les alternances du courant délivré par l'installation électrique domestique à travers le pont redresseur 42. Il n'y a pas de composante continue dans le courant de fuite et le disjoncteur différentiel 49 est opérationnel.

A la figure 8, le courant de fuite se produit entre la borne positive 50 de la batterie 41 et le châssis 48 du véhicule. Le courant de fuite comprend alors une composante continue provenant de la tension fournie par la batterie, composante continue que l'on retrouve ainsi dans le courant de fuite, et le disjoncteur différentiel 49 n'est plus opérationnel si ladite composante continue est trop élevée.

Une première solution pour éviter les risques que font encourir de tels disjoncteurs serait d'équiper l'installation électrique domestique d'un disjoncteur électriquement plus robuste. De tels disjoncteurs, dits de classe B, sont connus. Ils sont cependant rarement employés pour protéger des installations domestiques. Ils sont très chers, or les risques d'apparition (autre que lors de la charge) d'une composante continue supérieure aux normes sur un réseau domestique sont très faibles.

Par ailleurs, les usagers d'un véhicule ne sont pas nécessairement en mesure de vérifier si l'installation électrique domestique sur laquelle ils veulent se brancher est équipée d'un tel disjoncteur. Certains, par ignorance du risque ou poussés par la nécessité, pourraient de toute façon décider de connecter leur véhicule à une installation non équipée du disjoncteur approprié.

On peut aussi noter qu'il paraît commercialement peu pertinent d'exiger d'un acquéreur potentiel d'un véhicule électrique de changer son installation électrique s'il veut pouvoir recharger son véhicule depuis son domicile. Ceci constituerait un frein sérieux à la diffusion de ce type de véhicules. WO 2005/114805 A2 divulgue la détection d'un courant différentiel. FR 2 919 068 A1 divulgue un capteur de courant isolé qui est adapté à l'asservissement de dispositifs de puissance dans le domaine de l'avionique.

L'invention a pour objectif de résoudre ces difficultés et propose à cette fin un dispositif de détection d'un courant de fuite, par exemple alternatif et/ou continu, comprenant des moyens de mesure d'un courant issu d'un circuit électrique d'un véhicule, notamment véhicule automobile, ledit dispositif de détection étant configuré pour être embarqué dans ledit véhicule.

Un tel dispositif permet de détecter un courant de fuite à partir des seuls moyens présents dans le véhicule. Dans une application particulière, le dispositif permet de savoir s'il existe un risque d'envoyer vers l'installation électrique domestique à laquelle le véhicule est raccordé un courant présentant une composante continue trop importante, sans avoir à dépendre d'équipements extérieurs. L'usager du véhicule n'a ainsi plus besoin de savoir si l'installation électrique à laquelle il se raccorde est compatible. L'invention concerne un dispositif de détection d'un courant de fuite selon la revendication 1.

Selon différents modes de réalisation de l'invention, qui pourront être pris ensemble ou séparément:

- les moyens de mesure comprennent en outre des moyens pour sécuriser le fonctionnement de l'oscillateur ;
- les moyens de compensation de flux comprennent un troisième enroulement enroulé autour dudit tore, et dans lequel une sortie dudit module intégrateur-comparateur est reliée audit troisième enroulement de façon à ce que ledit troisième enroulement soit parcouru par ledit courant image du courant au primaire ;

- les moyens de compensation de flux sont formés par ledit enroulement secondaire et dans lequel une sortie dudit module intégrateur-comparateur est reliée audit enroulement secondaire de façon à ce que ledit enroulement secondaire soit parcouru par ledit courant image du courant au primaire ;
- lesdits moyens de mesure comprennent une résistance, dite de paramétrage, ayant une première borne reliée à l'enroulement secondaire et à l'oscillateur, et une seconde borne reliée à une borne de sortie du dispositif et au module intégrateur-comparateur de façon à ajuster les caractéristiques de sortie du dispositif et les caractéristiques de l'oscillateur ;
- lesdits moyens de mesure comprennent une résistance, dite d'ajustement, ayant une première borne reliée à l'enroulement secondaire et à l'oscillateur et une seconde borne reliée à une masse dudit dispositif de façon à ajuster les caractéristiques de l'oscillateur ;
- lesdits moyens de mesure comprennent une résistance, dite de mesure, ayant une première borne reliée à l'enroulement secondaire, et une seconde borne reliée à une borne de sortie du dispositif et au module intégrateur-comparateur de façon à ajuster les caractéristiques de sortie du dispositif ;
- les moyens de mesure comprennent des moyens de filtrage dudit courant image du courant au primaire permettant d'obtenir un signal présentant un profil sensiblement identique à celui du courant issu du circuit électrique ;
- les moyens de mesure comprennent des moyens pour ajuster la plage de tension en sortie du module de filtrage ;
- le dispositif comprend un générateur de masse fictive, lesdits moyens de mesure étant reliés à ladite masse fictive ;
- ledit oscillateur, et/ou ledit générateur de masse fictive, et/ou ledit module intégrateur-comparateur comprennent au moins un amplificateur opérationnel respectif ;
- ledit amplificateur opérationnel est tel que son temps de transition est inférieur à 50ns ;
- ledit amplificateur opérationnel est relié en sortie à un amplificateur de courant.

L'invention concerne aussi un système de protection électrique de la charge d'une batterie embarquée dans un véhicule, notamment automobile, comprenant un dispositif de détection d'un courant de fuite selon l'invention.

Ledit système de protection comprend, par exemple, des moyens de contrôle permettant de faire fonctionner en mode dégradé un circuit servant à la charge de ladite batterie.

L'invention concerne encore un système de mesure d'une impédance de terre d'une installation domestique servant à la charge d'une batterie de véhicule automobile, ledit système de mesure comprenant un dispositif de détection d'un courant de fuite selon l'invention.

L'invention concerne aussi un système de charge d'une batterie embarquée dans un véhicule, ledit système de charge comprenant un tel système de protection électrique et/ou un tel système de mesure d'impédance de terre.

Les différents systèmes évoqués plus haut sont configurés pour être embarqués dans un véhicule et l'invention concerne encore un véhicule comportant ledit dispositif de détection et/ou l'un ou plusieurs desdits systèmes.

En munissant le véhicule de systèmes de protection électrique exploitant les mesures obtenues par ledit dispositif de détection, on pourra éviter de mettre en danger les personnes passant à proximité du véhicule ainsi que les occupants du domicile sur lequel le véhicule est branché. Ils seront en effet protégés par le disjoncteur différentiel du domicile, quel que soit son type. Ledit dispositif de détection pourra avoir d'autres applications comme de permettre la vérification de l'impédance de terre de l'installation domestique sur laquelle il est branché.

L'invention concerne enfin un procédé de charge d'une batterie, notamment d'un véhicule, comprenant :

- la fourniture d'un système de charge selon l'invention ;
- la charge de la batterie avec une correction de facteur de puissance par l'intermédiaire dudit système de charge ;
- la poursuite de la charge sans la correction de facteur de puissance lorsqu'un rapport entre une composante continue du courant de fuite et une composante alternative de ce courant de fuite est supérieur à un seuil prédéterminé.

Des modes de réalisation de l'invention vont maintenant être décrits de façon plus précise, mais non limitative, en regard des dessins annexés sur lesquels :

- les figures 1 à 3, déjà commentées, illustrent de façon schématique les risques liés à la recharge des batteries d'un véhicule électrique de l'état de l'art,
- la figure 4, déjà commentée, illustre de façon schématique un disjoncteur différentiel de l'état de l'art,
- les figures 5 et 6, déjà commentées, représentent des courbes d'aimantation dans le but d'illustrer l'effet d'un courant présentant une composante continue sur les disjoncteurs différentiels du type de celui de la figure 4,
- les figures 7 et 8, déjà commentées, illustrent de façon schématique un véhicule de l'état de l'art muni d'un dispositif de charge d'une batterie, dans le but d'illustrer les risques d'apparition d'un courant de fuite présentant une composante continue,
- la figure 9 illustre de façon schématique un véhicule équipé d'un dispositif de détection conforme à l'invention,

- la figure 10 illustre de façon schématique un premier exemple de réalisation du dispositif de détection conforme à l'invention, servant à mesurer une composante continue dans un courant au primaire,
- la figure 11 illustre une courbe donnant, en fonction du temps, la variation d'un courant circulant dans ledit dispositif, en absence d'une composante continue dans le circuit primaire,
- la figure 12 est une courbe d'aimantation illustrant le fonctionnement dudit dispositif, en présence et en absence d'une composante continue dans le courant au primaire,
- la figure 13 reprend la figure 11 pour comparer les courbes obtenues en présence et en absence d'une composante continue dans le courant au primaire,
- la figure 14 illustre de façon schématique un second exemple de réalisation du dispositif de détection conforme à l'invention,
- la figure 15 illustre de façon schématique un troisième exemple de réalisation du dispositif de détection conforme à l'invention,
- la figure 16 illustre de façon schématique un système de protection électrique de la charge d'une batterie conforme à l'invention,
- les figures 17a à 17c donnent sous la forme de diagrammes temporels différents profils de courant en relation avec l'invention,
- la figure 18 illustre de façon schématique un autre exemple de réalisation du dispositif de détection conforme à l'invention.
- la figure 19 illustre de façon schématique un quatrième exemple de réalisation du dispositif de détection conforme à l'invention,

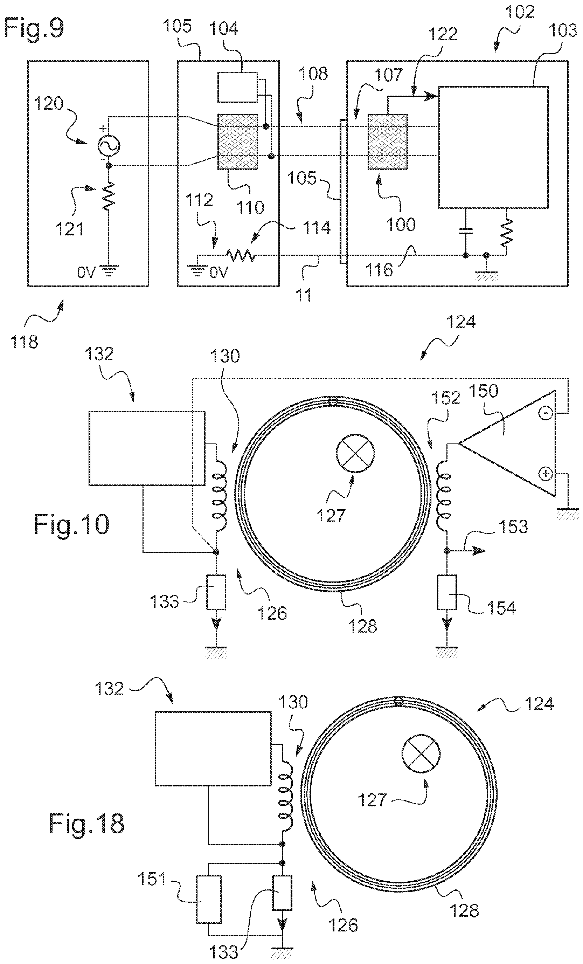

Comme illustré à la figure 9, l'invention concerne un dispositif 100 de détection d'un courant de fuite configuré pour être embarqué dans un véhicule 102. Il pourra en particulier s'agir d'un véhicule, notamment automobile, à entraînement électrique, c'est-à-dire, un véhicule comprenant une machine électrique servant à la traction et/ou à la propulsion du véhicule, en étant couplée ou non à un moteur thermique. Autrement dit, il pourra aussi bien s'agir d'un véhicule dit électrique que d'un véhicule dit hybride. Ladite machine électrique est alimentée par une batterie, non représentée, embarquée dans ledit véhicule 102.

Ledit véhicule 102 comprend un circuit électrique 103 servant, notamment, à recharger ladite batterie. Ledit circuit 103 pourra être, comme illustré, un circuit alimenté de façon monophasée ou de façon polyphasée, notamment triphasé. Il est ici relié à une installation électrique domestique 104 d'une habitation 105, par l'intermédiaire d'une borne de connexion 106 du véhicule 102. Une ligne d'alimentation 107 est prévue entre ledit circuit 103 et ladite borne de connexion 106. Ledit dispositif de protection est situé sur la ligne d'alimentation 107. On pourra utiliser un câble électrique 108 pour relier ladite borne de connexion 106 à ladite installation domestique 104.

Ladite habitation 105 comprend un disjoncteur différentiel 110 protégeant ladite installation domestique 104. L'habitation comprend également un câble de mise à la terre 112 présentant une impédance de mise à la terre symbolisée par la résistance 114. La borne de connexion 106 est configurée pour relier un conducteur de masse 116 du véhicule (ici la masse est le châssis du véhicule), à un conducteur de terre 11 du câble 108, relié à ladite impédance de terre 114.

Ladite habitation 105 est alimentée par un réseau 118 comprenant de façon classique une source de tension 120, notamment de basse tension alternative. L'installation électrique domestique 104 est raccordée au réseau par l'intermédiaire du disjoncteur différentiel 110. Ledit réseau 118 comprend sa propre impédance 121 de mise à la terre.

Ledit dispositif de détection 100 est configuré pour être relié à une unité de contrôle du circuit électrique 103 du véhicule, notamment par l'intermédiaire d'un câble 122.

Comme illustré à la figure 10, ledit dispositif de détection comprend des moyens de mesure 124 d'un courant généré par le circuit électrique du véhicule.

Lesdits moyens de mesure 124 comprennent, par exemple, des moyens 126 de génération d'un flux magnétique à partir du courant généré par le circuit électrique.

Par exemple, le courant circule dans un élément conducteur 127 dudit circuit électrique 103 du véhicule. Il pourra s'agir, par exemple, de la phase ou du neutre de la ligne d'alimentation 107 du circuit 103. En mode normal, ledit élément conducteur 127 est destiné à être parcouru par un courant alternatif. En cas d'anomalie, il pourra aussi être traversé par des courants de fuite, alternatifs et/ou continus.

De manière équivalente, le courant peut correspondre à la somme résultante de courants circulant dans plusieurs éléments conducteurs 127 différents. En particulier dans une installation monophasée, le courant est la résultante des courants circulant dans la phase et le neutre de la ligne d'alimentation 107.

Lesdits moyens 126 de génération du flux magnétique comprennent, notamment, un tore magnétique 128, configuré pour être parcouru par un flux magnétique provenant du courant circulant dans ledit élément conducteur 127.

Ledit tore magnétique 128 est constitué, par exemple, d'un matériau magnétique présentant une perméabilité relative maximale $\mu$r comprise entre 5000 et 150000, notamment de l'ordre de 15000 et/ou un champ coercitif Hc compris entre 1 et 3 A/m. Il pourra en particulier s'agir de ferrite ou de matériaux amorphes.

Le tore 128 est configuré pour être traversé par ledit élément conducteur 127, formant enroulement primaire. Autrement dit, ledit enroulement primaire 127 comprend une spire. On entend par là que le tore magnétique 128 est configuré pour que ledit enroulement primaire passe de façon rectiligne à travers ledit tore 128.

Lesdits moyens 126 de génération du flux magnétique comprennent un enroulement secondaire 130, enroulé autour dudit tore 128, pour générer un flux magnétique parcourant ledit tore à partir d'un courant de référence.

Lesdits moyens de mesure 124 comprennent en outre, par exemple, un oscillateur 132 générant ledit courant de référence à travers l'enroulement secondaire. Ledit oscillateur est ici relié d'une part à une première borne de l'enroulement secondaire 128 et de l'autre à une seconde borne dudit enroulement secondaire 128, seconde borne à laquelle est reliée une résistance 133 desdits moyens de mesure 124. Ladite résistance 133 est située entre ladite seconde borne et la masse. L'oscillateur 132 génère, par exemple, une tension de type carré prenant alternativement les deux valeurs +Vmax et -Vmax. L'oscillateur est ici configuré pour passer de +Vmax à -Vmax et réciproquement dès qu'un maximum ou un minimum de courant Ip+ ou Ip- dans l'enroulement secondaire 130 est atteint. La résistance 133 permet d'ajuster les oscillations délivrées au second enroulement 130, notamment les valeurs de courant crête Ip+ ou Ip- du second enroulement 130.

Lesdits moyens de mesure 124, en particulier ledit oscillateur 132 et ledit enroulement secondaire 130 sont configurés pour saturer ledit tore 128, sous l'action du courant crête.

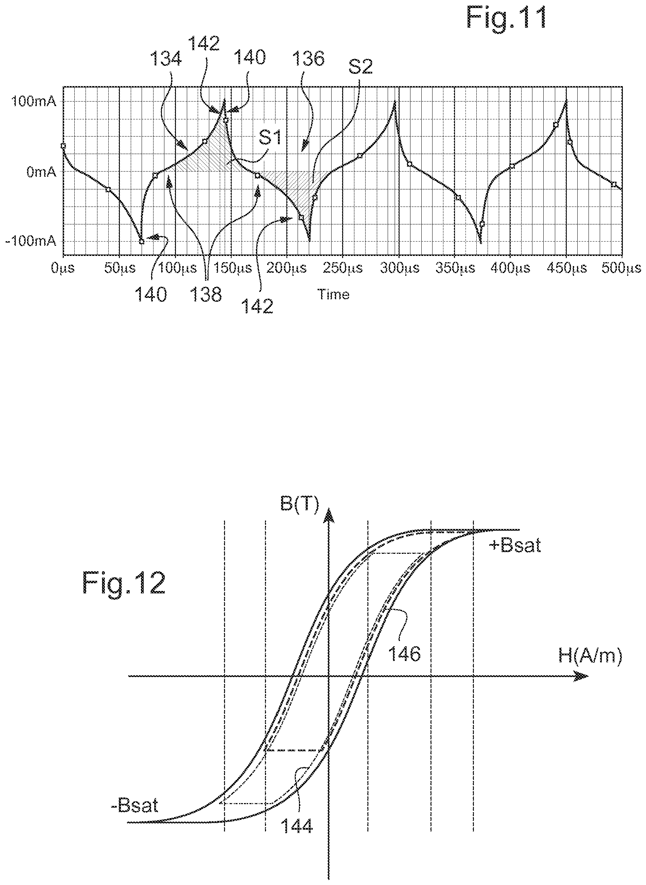

On décrit en référence à la figure 11 la forme du courant traversant l'enroulement secondaire 130 sous l'effet de la tension délivrée par un tel oscillateur 132. A cette figure, l'intensité du courant est illustrée en ordonnée et le temps est illustré en abscisse. En réponse au signal de tension carré délivré par l'oscillateur, le courant dans l'enroulement secondaire 130 présente des phases ascendantes 134 et descendantes 136 alternant les unes avec les autres. Dans une partie intermédiaire 138 de chacune desdites phases ascendantes et descendantes 134, 136 le courant généré dans l'enroulement secondaire 130 correspond à un état non saturé du tore 128. Dans ces parties intermédiaires, le courant croit ou décroît relativement lentement. Dans les parties de début 140, ou de fin 142 de chacune desdites phases ascendantes et descendantes 134, 136, le courant généré dans l'enroulement secondaire correspond par contre à un état saturé du tore magnétique 128 et le courant croit ou décroît de façon relativement rapide.

Le cycle correspondant de magnétisation et de démagnétisation du tore 128 est illustré à la figure 12 en cas de présence ou non d'un courant circulant dans l'enroulement primaire.

La courbe en trait plein est la courbe de magnétisation maximale.

La courbe 144, illustrée par des points, correspond au cas où il n'y a pas de courant circulant dans l'enroulement primaire. Dans ce cas, on constate que les valeurs extrêmes de l'induction correspondent à des zones de saturation de la matière. On constate également que les valeurs extrêmes sont égales en valeur absolue. Ceci se traduit sur la courbe de la figure 11 par des valeurs extrêmes Ip+, Ip- de courant circulant dans l'enroulement secondaire qui sont aussi égales en valeur absolue et de signe opposé. Ceci se traduit encore par une égalité des surfaces S1 et S2, respectivement situées entre l'axe des abscisses et la partie positive des phases ascendantes et descendantes 134, 136 et entre l'axe des abscisses et la partie négative des phases ascendantes et descendantes 134, 136, c'est-à-dire, par une valeur moyenne nulle du courant circulant dans ledit enroulement secondaire.

La courbe 146, illustrée par des tirets, correspond au cas dans lequel, on introduit un courant dans l'enroulement primaire. Par rapport à la courbe 144, la courbe 146 est décalée vers les valeurs positives d'induction comme représenté. Le niveau de saturation du matériau magnétique est plus élevé dans les valeurs positives que dans les valeurs négatives quand le courant primaire génère un champ magnétomoteur positif.

Inversement, le niveau de saturation du matériau magnétique est plus élevé dans les valeurs négatives que dans les valeurs positives quand le courant primaire génère un champ magnétomoteur négatif. Dans ce cas, par rapport à la courbe 144, la courbe 146 serait décalée vers les valeurs négative d'induction.

Autrement dit, la présence d'un courant dans l'enroulement primaire 127 modifie l'état magnétique du tore 128, ce qui entraîne une modification du cycle de magnétisation et de démagnétisation du tore 128 et du courant au secondaire.

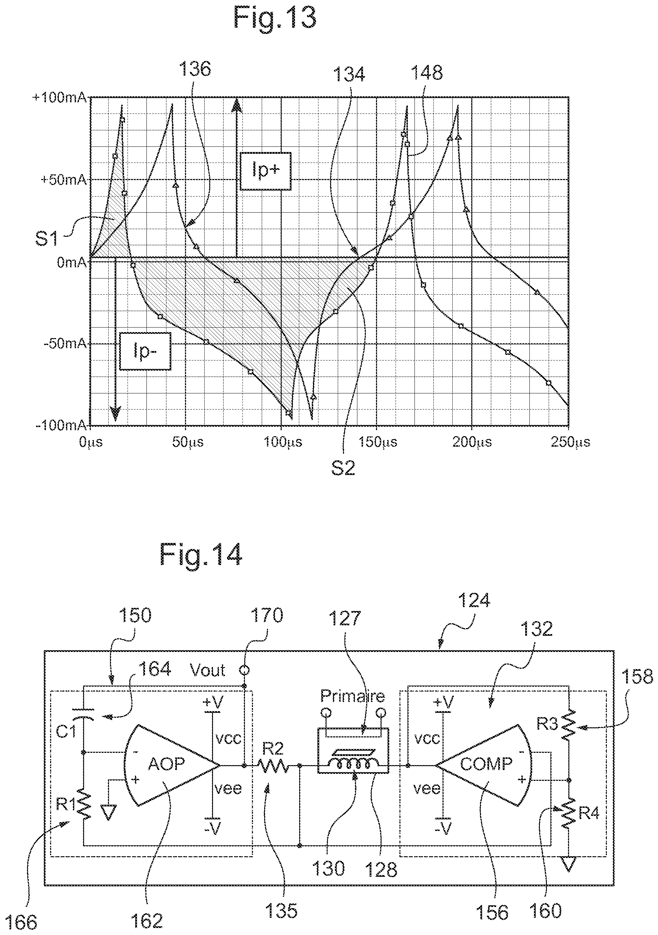

On a illustré à la figure 13, la courbe 148 donnant l'intensité du courant dans l'enroulement secondaire 130 en fonction du temps dans le cas d'un champ magnétomoteur positif. Les phases ascendantes et descendantes 134, 136 de la courbe 138 en cas d'absence de courant circulant dans l'enroulement primaire ont également été représentées pour faciliter les comparaisons.

On retrouve dans la courbe 148 la dissymétrie de la courbe 146 de magnétisation et démagnétisation. Les vitesses d'évolution du courant au secondaire sont beaucoup plus élevées dans la partie positive que dans la partie négative, car on sature mieux dans la partie positive que dans la partie négative. Ceci permet d'expliquer la différence entre les surfaces S1, S2 des parties positives et négatives. Autrement dit, la valeur moyenne du courant circulant dans l'enroulement secondaire n'est plus nulle. Cette valeur moyenne dépend du courant qui circule dans l'enroulement primaire.

Par conséquent, lorsque le courant de l'enroulement primaire varie, la valeur moyenne du courant au secondaire sur une période d'oscillation varie proportionnellement. Ainsi, en observant le courant au secondaire, on remonte à la valeur du courant dans l'enroulement primaire. On dispose de la sorte d'une solution permettant de mettre en évidence la présence et même de quantifier la valeur du courant circulant dans l'enroulement primaire. En outre, grâce aux moyens 126 de génération de flux magnétique, une mesure du courant dans l'enroulement primaire est obtenue tout en ayant une isolation galvanique entre le circuit 103 du véhicule et le circuit mis en oeuvre pour la mesure.

Il est préférable que les valeurs de courant au secondaire 130 permettent d'atteindre une saturation du tore 128. Les figures 12 et 13 illustrent l'intérêt de la saturation du tore. On constate en effet que, grâce à ce phénomène, l'amplitude de variation d'induction change de façon significative en fonction du niveau de courant passant dans l'enroulement primaire. On améliore de la sorte la précision de la mesure.

Pour garantir un bon niveau de saturation du matériau magnétique, il est nécessaire que le courant circulant dans l'enroulement secondaire soit suffisamment élevé. Par exemple, le courant maximum en valeur absolue circulant dans ledit enroulement secondaire est de l'ordre de 100 mA avec une bonne saturation du tore 128.

Par ailleurs, le courant circulant dans l'enroulement primaire peut être est de type variable. Par exemple, le courant peut avoir une fréquence de 50 Hz. Pour que la fréquence de l'oscillateur permette d'obtenir des mesures de ce courant circulant dans l'enroulement primaire, il est nécessaire que la fréquence de cet oscillateur soit très supérieure à celle du courant circulant dans ledit enroulement primaire, notamment au moins 10 fois plus élevée, par exemple 100 fois plus élevée. Ceci permet de reconstituer le courant au primaire de façon suffisamment fidèle pour son exploitation. La fréquence de l'oscillateur 132 peut être située entre 1 et 20 kHz. En particulier, la fréquence de l'oscillateur 132 peut être de 7 kHz pour permettre la mesure d'un courant de fréquence 50Hz au primaire. Autrement dit, on cherche à reproduire la forme d'onde du courant au primaire 127 avec par exemple une erreur de 5 à 10% sur les valeurs crêtes.

Des résultats avantageux ont été obtenus dans ce sens en choisissant pour l'enroulement secondaire 130 un nombre de spires compris entre 10 et 50 spires, notamment entre 20 et 30 spires pour un enroulement primaire ayant une spire.

Cependant, l'enroulement primaire 127 pourrait présenter plus d'une spire. L'enroulement secondaire 130 a alors un nombre correspondant de spires.

Selon un premier mode de réalisation, illustré en figure 18, les moyens de mesure 124 comprennent des moyens de traitement numérique 151 permettant d'obtenir la valeur du courant circulant dans ledit élément conducteur 127 d'après le courant circulant dans l'enroulement secondaire 130. Autrement dit, on sort directement la valeur du courant au secondaire tel que présenté en figure 13 vers un microcontrôleur ou un circuit numérique. La valeur du courant au primaire est déduite par un traitement du signal.

Cependant, le dispositif selon ce premier mode de réalisation donne un résultat moins performant en terme de linéarité par rapport aux modes de réalisation qui suivent. En se référant à la figure 12, on comprend que de fortes valeurs de courant au primaire 127 rapprochent la courbe 146 de la valeur extrémale +Bsat si le champ magnétomoteur est positif ou de la valeur extrémale -Bsat si le champ magnétomoteur généré est négatif. Ceci implique que pour de fortes valeurs de courant au primaire, une relation linéaire entre le courant au primaire 127 et la valeur de celui au secondaire 130 n'est plus garantie. Autrement dit, lorsque le tore 128 est fortement éloigné de son état magnétique neutre, correspondant par exemple à la courbe 144 en figure 12 ou à la courbe 138 en figure 11, une mesure fiable du courant au primaire n'est plus assurée.

Dans un deuxième et un troisième mode de réalisation illustrés en figures 10, 14 et 15, pour quantifier la valeur du courant circulant dans l'enroulement primaire 127, les moyens de mesure 124 comprennent un module intégrateur-comparateur 150 délivrant un courant de sortie, dit image du courant au primaire, qui est fonction du courant de fuite à mesurer.

Le module 150 intègre le courant provenant de l'enroulement secondaire 130 et compare sa valeur moyenne avec une valeur nulle. Le module intégrateur-comparateur 150 délivre un courant qui est fonction de la différence entre la valeur moyenne du courant au secondaire 130 avec une valeur nulle. A cet effet, cette différence est fortement amplifiée, par exemple avec un gain supérieur à 70dB. Le module 150 est configuré pour modifier son courant de sortie tant que la différence n'est pas sensiblement nulle.

Les moyens de mesure 124 comprennent en outre des moyens pour compenser le flux généré dans le tore 128 par le courant circulant dans ledit élément conducteur 127, à partir du courant délivré par ledit module intégrateur-comparateur 150.

Ainsi, le tore 128 est constamment ramené à un état magnétique neutre, la valeur moyenne du courant au secondaire est constamment ramenée à une valeur nulle et le courant délivré par le module 150 correspond au courant parcourant l'élément conducteur 127, autrement dit au courant de fuite à mesurer. Le module 150 et les moyens de compensation de flux définissent une boucle d'asservissement contrôlant l'état magnétique du tore 128.

Ledit module intégrateur-comparateur 150 est relié audit enroulement secondaire 130. En particulier, ledit module intégrateur-comparateur 150 comprend une entrée inverseuse, reliée à ladite seconde borne de l'enroulement secondaire 130, notamment par l'intermédiaire d'une résistance 166, et une entrée non inverseuse reliée à la masse.

Selon le deuxième mode de réalisation, correspondant à celui illustré à la figure 10, lesdits moyens de compensation correspondent à un troisième enroulement 152, enroulé autour dudit tore 128. Les moyens de mesure sont configurés de façon à ce que ledit troisième enroulement 152 génère dans le tore un flux magnétique, dit flux de compensation, opposé à celui généré par ledit enroulement primaire ; le flux de compensation étant généré à partir du courant délivré par le module intégrateur-comparateur 150.

Ledit troisième enroulement 152 est relié à la sortie du module intégrateur-comparateur 150 de façon à ce que ledit troisième enroulement soit parcouru par le courant image du courant au primaire.

Par exemple, la borne du troisième enroulement 152 opposée à celle reliée au module intégrateur-comparateur 150, dite borne de sortie 153, est reliée à une résistance de sortie 154 elle-même connectée par sa borne opposée à la masse. La tension $V_{OUT}$ à la borne de sortie est ainsi égale au produit de la résistance $R_s$ de ladite résistance de sortie 154 et du quotient de l'intensité du courant $I_e$ circulant dans l'enroulement primaire 127 par le nombre de tours $N$ dudit troisième enroulement 152. On dispose ainsi de l'intensité $I_e$ du courant circulant dans l'enroulement primaire 127 par une simple mesure de la tension à ladite borne de sortie 153.

$$V_{OUT} = R_s \times ( I_e / N )$$

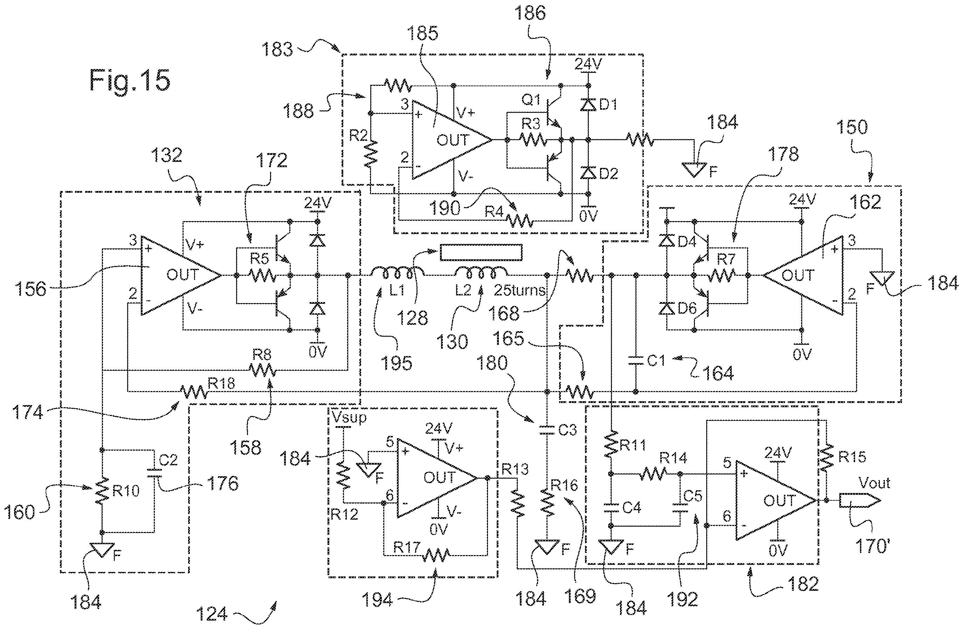

Le troisième mode de réalisation est illustré en figures 14 et 15. Dans ces figures, le tore 128 est illustré de façon schématique. On remarquera par ailleurs que l'enroulement primaire n'a pas été illustré à la figure 15.

Dans ce troisième mode de réalisation, lesdits moyens de compensation correspondent à l'enroulement secondaire 130. Une sortie du module intégrateur-comparateur 150 est reliée à l'enroulement secondaire 130 et lesdits moyens de mesure 124 sont configurés pour que le module intégrateur-comparateur 150 génère un courant circulant dans l'enroulement secondaire 130 de façon à compenser le flux généré par l'enroulement primaire 127. Autrement dit, dans ce mode de réalisation, le flux magnétique généré dans le tore 128 par le courant circulant dans l'enroulement primaire 127 n'est plus compensé par un flux généré par un courant parcourant une troisième bobine. Les moyens de mesure 124 sont configurés pour que le flux de compensation soit généré directement par un courant de compensation parcourant l'enroulement secondaire 130. Dans ce mode de réalisation, il n'est donc pas nécessaire d'utiliser un troisième enroulement 152.

En figures 14 et 15, on constate que l'oscillateur 132 comprend un amplificateur opérationnel 156 et un pont diviseur de tension comprenant deux résistances 158, 160. Le point milieu dudit diviseur de tension est relié à l'entrée non inverseuse dudit amplificateur opérationnel 156. La sortie de l'amplificateur opérationnel 156, la borne de l'une 158 des résistances opposée au point milieu dudit diviseur de tension et l'une des bornes du second enroulement 130 sont au même potentiel. L'autre 160 des résistances dudit pont diviseur de tension est reliée à la masse.

Le module intégrateur-comparateur 150 comprend un amplificateur opérationnel 162 et un pont RC comprenant une capacité 164 et une résistance 166. L'entrée non inverseuse dudit amplificateur opérationnel 162 est reliée à la masse. Son entrée inverseuse est reliée au point milieu du pont RC.

Dans une variante illustrée en figure 14, les moyens de mesure 124 comprennent une résistance 135, dite de paramétrage. L'une des bornes de ladite résistance de mesure est mise au même potentiel que l'entrée inverseuse de l'amplificateur opérationnel 156 de l'oscillateur 132, la borne de l'enroulement secondaire 130 opposée à celle reliée à la sortie dudit amplificateur opérationnel 156 de l'oscillateur 132, et la borne de la résistance 166 du pont RC opposée au point milieu dudit pont RC. L'autre des bornes de ladite résistance de mesure 135 est mise au même potentiel que la sortie dudit amplificateur opérationnel 162 du module intégrateur-comparateur 150, la borne de la capacité 164 du pont RC opposée au point milieu dudit pont RC, et un point de sortie 170.

Selon cette variante, ladite résistance de mesure 135 joue un double rôle.

La résistance 135 permet de paramétrer l'oscillateur 132, notamment les valeurs crête Ip+, Ip- du courant au secondaire 130.

En outre, la résistance 135 relie le second enroulement 130 à la sortie du module intégrateur-comparateur 150 pour la circulation du courant de compensation. Ladite résistance de mesure 135 sert de résistance de sortie au sens de la configuration du mode de réalisation de la figure 11. Une mesure de la tension au niveau du point de sortie 170 donnera la valeur du courant circulant dans l'enroulement primaire 127.

Cependant, la résistance 135 ne pouvant prendre qu'une seule valeur, elle doit respecter un compromis entre les spécifications de l'oscillateur 132 et celles liées à la mesure de la tension au niveau du point de sortie 170. La variante illustrée en figure 15 permet de s'affranchir de ce problème.

Selon la variante illustrée à la figure 15, Les moyens de mesure 124 comprennent une résistance 169, dite d'ajustement, placée entre une borne de l'enroulement secondaire 130, située entre ledit enroulement secondaire et ledit oscillateur 132, et une masse dudit dispositif. La résistance d'ajustement 169 permet d'adapter les caractéristiques de l'oscillateur 132, notamment en vue d'assurer la saturation du tore 128. La capacité 180 permet d'éliminer une composante continue dans le courant délivré à la résistance d'ajustement 169. Ainsi, la résistance d'ajustement 169 ne reçoit que le courant oscillant déterminé par l'oscillateur 132.

Les moyens de mesure 124 comprennent en outre une résistance 168, dite de mesure, qui sert de résistance de sortie au sens de la configuration du mode de réalisation de la figure 11.

On sépare de la sorte les fonctions de résistance de l'oscillateur et de conducteur servant à établir le courant de compensation, sans avoir à ajouter un troisième enroulement tel que celui de la figure 10.

Il est à noter que la figure 15 présente un schéma électrique développé, contrairement à la figure 14 qui présente un schéma électrique semi-développé. Certains éléments de la variante illustrée en figure 15 peuvent être intégrés de façon similaire dans la variante de la figure 14, notamment un amplificateur de courant 172 et une résistance 174 de l'oscillateur 132, et un amplificateur de courant 178 du module intégrateur-comparateur 150, ainsi qu'un module de filtrage 182, des moyens 194 permettant d'ajuster la plage de tension du signal de sortie, un générateur 183 de masse fictive 184, et des moyens de sécurisation 193, 195, 196 du fonctionnement de l'oscillateur.

La sortie de l'amplificateur opérationnel 156 de l'oscillateur 132 est par exemple reliée à une entrée de l'amplificateur de courant 172. La sortie dudit amplificateur de courant 172, la borne de l'une 158 des résistances opposée au point milieu dudit diviseur de tension et l'une des bornes du second enroulement 130 sont au même potentiel.

L'oscillateur 132 peut comprendre la résistance 174 dont une première borne est reliée à l'entrée inverseuse de l'amplificateur opérationnel 156 dudit oscillateur 132.

La sortie de l'amplificateur opérationnel 162 du module intégrateur-comparateur 150 est par exemple reliée à une entrée de l'amplificateur de courant 178. L'une des bornes de ladite résistance de mesure 168 est mise au même potentiel que la sortie dudit amplificateur de courant 178, la borne de la capacité 164 du pont RC du module intégrateur-comparateur 150 opposée au point milieu dudit pont RC, et le point de sortie 170.

L'autre borne de la résistance de mesure 168 est mise au même potentiel qu'une seconde borne de la résistance 174, la borne de l'enroulement secondaire 130 opposée à celle reliée à la sortie dudit amplificateur de courant 152 de l'oscillateur 132, et la borne de la résistance 166 du pont RC du module intégrateur-comparateur 150 opposée au point milieu dudit pont RC. Cette borne est également au même potentiel que l'une des bornes de la résistance d'ajustement 169, ici par l'intermédiaire d'une capacité 180.

Grâce aux différents circuits décrits plus haut, la présence et même le niveau d'un courant au primaire est ainsi déterminable.

A ce sujet, lesdits moyens de mesure pourront en outre comprendre un module de filtrage 182, reliant le point de sortie 170 à un point de mesure de tension 170'. Ledit module de filtrage 182 est configuré pour éliminer du signal les ondulations provenant de l'oscillateur 132. Au niveau des bornes d'une capacité 192 dudit module de filtrage 182, on dispose ainsi d'un signal, notamment une tension, présentant un profil sensiblement identique à celui du courant circulant dans l'élément conducteur 127.

Pour faciliter le traitement dudit signal, les moyens de mesure pourront en outre comprendre des moyens 194 permettant d'ajuster la plage de tension du signal disponible au niveau du point de sortie 170' du dispositif. Par exemple, les moyens d'ajustement 194 sont configurés pour que la tension de sortie soit une plage de tension positive déterminée à partir d'une alimentation Vsup. Ceci facilite un traitement ultérieur du signal de sortie, par exemple par une unité de contrôle. Par exemple, un courant au primaire de -100 mA correspond à une tension de sortie Vout de 0V ; un courant au primaire de 0 mA correspond à une tension de sortie

Vout de valeur $\dfrac{V \sup}{2}$ ; et un courant au primaire de 100 mA correspond à une tension de sortie Vout de valeur Vsup. Dans le cas où le signal de sortie Vout est ensuite traité par une unité de contrôle, l'alimentation Vsup peut correspondre à l'alimentation de cette unité de contrôle.

Différents moyens pourront en outre être employés pour fiabiliser la mesure, notamment en assurant l'obtention d'un courant qui soit le plus symétrique possible dans l'enroulement secondaire 130 en cas d'absence de courant circulant dans l'enroulement primaire 127. On entend par là un courant pour lequel les surfaces S1 et S2 évoquées plus haut soient les plus proches possibles, avec un minimum d'erreur, en particulier d'erreur de type offset.

A cet effet, ledit dispositif de détection 100 peut comprendre un générateur 183 de masse fictive 184, lesdits moyens de mesure 124 étant reliés à ladite masse fictive 184. Plus précisément, la résistance 160 du pont diviseur de tension dudit oscillateur 132, la résistance d'ajustement 169 et/ou l'entrée inverseuse de l'amplificateur opérationnel 162 du module intégrateur-comparateur 150 pourront être reliées à ladite masse fictive 184. Le générateur 183 de masse fictive a pour but de générer deux alimentations symétriques de valeurs aussi identiques que possible, pour limiter au maximum les dissymétries d'amplitude de l'oscillateur qui influent sur l'offset de la mesure.

Ledit générateur de masse fictive 184 comprend un amplificateur opérationnel 185 dont la sortie est reliée à ladite masse fictive par un amplificateur de courant 186. Ledit générateur de masse fictive 184 comprend en outre un pont diviseur de tension 188 dont le point milieu est relié à l'entrée non inverseuse de l'amplificateur opérationnel 185. Les extrémités du pont diviseur de tension ainsi que l'amplificateur de courant sont connectés à une source d'alimentation en tension, notamment entre 0 et 24V. Ledit générateur de masse fictive comprend encore une résistance 190 placée entre la masse fictive et l'entrée inverseuse dudit amplificateur opérationnel 185.

Une autre solution contribuant à assurer l'obtention d'un courant dans l'enroulement secondaire qui soit le plus symétrique possible en cas d'absence de courant circulant dans l'enroulement primaire consiste dans l'utilisation des amplificateurs de courant 172, 178, 186 en sortie des amplificateurs opérationnels 156, 162, 185 des moyens de mesure et/ou du générateur de masse fictive. On pourra de la sorte choisir des amplificateurs opérationnels précis tout en restant de coût limité car ayant moins de courant à délivrer. Dans le même esprit, lesdits amplificateurs de courant 172, 178, 186 comprennent, par exemple, des transistors bipolaires.

Toujours dans le but d'obtenir un courant dans l'enroulement secondaire qui soit le plus symétrique possible en cas d'absence de courant circulant dans l'enroulement primaire, le ou les amplificateurs opérationnels 156, 162, 185 des moyens de mesure et/ou du générateur de masse fictive pourront être choisis de façon à assurer des temps de transition entre les valeurs +Vmax et -Vmax de leur tension de sortie inférieurs à 50 ns. C'est en particulier le cas pour l'amplificateur opérationnel 156 de l'oscillateur 132. On évite de la sorte d'apporter une dissymétrie temporelle aux signaux générés illustrés en figure 11.

Selon une variante de tous les modes de réalisation du dispositif de détection 100, les moyens de mesure 124 comprennent en outre des moyens 193, 195, 196 pour sécuriser le fonctionnement de l'oscillateur 132.

Lorsque le courant au primaire est très élevé, le tore 128 sature fortement en permanence, ce qui entraîne une augmentation de la fréquence de l'oscillateur 132. Un courant très élevé au primaire est par exemple de l'ordre 1A, voir 10A. La fréquence de l'oscillateur 132 peut alors être si élevée que le module intégrateur-comparateur 150 est susceptible de ne pas pouvoir traiter le signal délivré par l'oscillateur. Une forte saturation du tore 128 peut même entraîner l'arrêt des oscillations. Ceci entraîne une instabilité du dispositif de détection 100. La tension de sortie Vout ne correspond plus alors avec certitude au courant au primaire. Il y a un risque que la tension de sortie donne une valeur minorée du courant au primaire, ce qui peut affecter la sécurité électrique du véhicule.

Les moyens de sécurisation 193, 195, 196 contrôlent la fréquence de l'oscillateur 132 de façon à s'assurer que l'oscillateur fonctionne correctement.

Par exemple, les moyens de sécurisation consistent en une inductance 196 en série entre l'oscillateur 132 et l'enroulement secondaire 130. L'inductance 196 n'est pas enroulé sur le tore 128 et est donc sensiblement indépendant de l'état magnétique du tore. L'inductance 196 assure que l'oscillateur 132 oscille même quand le courant au primaire est très élevé. L'inductance 196 se substitue alors à l'enroulement secondaire 130 qui est trop saturé, et détermine la fréquence de l'oscillateur 132. Par exemple, l'inductance 196 assure une fréquence d'oscillation Fmax qui est compatible avec le module intégrateur-comparateur 150. La tension de sortie Vout se stabilise à une tension correspondante qui indique que le courant au primaire est très élevé ou hors de la gamme de mesure du dispositif.

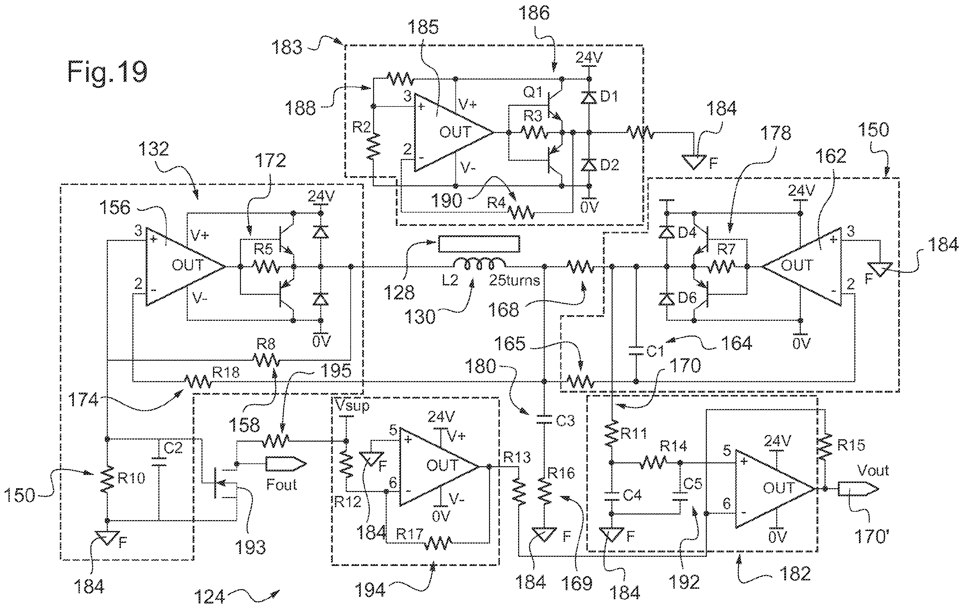

Par exemple, les moyens de sécurisation consistent en des moyens de mesure 193, 195 de la fréquence de l'oscillateur 132 comme illustré en figure 19. Ainsi, on peut vérifier que l'oscillateur 132 fonctionne dans la gamme de fréquence prévue par conception. Par exemple, on s'assure que la fréquence reste dans une plage de plus ou moins 25%. La figure 19 correspond à la variante de la figure 15 dans laquelle l'inductance 196 est remplacée par le transistor 193 et la résistance 195.

Les moyens de mesure peuvent comprendre un transistor 193 dont la tension de grille correspond à la tension aux bornes de la résistance 160 connectée entre la masse et l'entrée non inverseuse de l'amplificateur opérationnel 156 de l'oscillateur 132. Le drain du transistor 193 est connecté par une résistance 195 à une alimentation. Cette alimentation est par exemple la même alimentation Vsup utilisée par le dispositif 194 d'ajustement de plage de tension.

Le transistor 193 peut être un transistor MOSFET. La tension drain-source du transistor 193 correspond à la fréquence Fout de l'oscillateur 132.

La fréquence maximale d'oscillation dépend entre autres du matériau magnétique du tore 128, du nombre de spires de l'enroulement secondaire 130 et du courant au primaire.

L'invention concerne en outre un système de détection de composante continue comprenant le dispositif de détection 100 de courant de fuite selon l'invention et des moyens 214 de détection d'une composante continue dans le courant de fuite.

Les moyens 214 de détection d'une composante continue peuvent assurer la détection du dépassement d'un seuil par un minimum du signal délivré par les moyens de mesure 124.

Par exemple, à partir du signal délivré par les moyens de mesure 124 du dispositif de détection 100, les moyens 214 de détection d'une composante continue peuvent vérifier que le courant mesuré au primaire 127 passe par zéro au moins une fois par période, la période étant déterminée, par exemple, par la fréquence du secteur auquel est relié le circuit 103 du véhicule 102.

Si tel n'est pas le cas, c'est-à-dire si le courant ne passe pas par zéro, les moyens 214 de détection d'une composante continue mesurent de combien la valeur minimale du courant mesuré s'écarte de zéro. Cette valeur minimale doit être inférieure à un seuil prédéterminé Is, déterminé par exemple par des normes en vigueur, notamment un seuil d'une valeur de 6 mA. Sinon, les moyens de détection 214 indiquent la présence d'une composante continue dans l'élément conducteur 127, c'est-à-dire dans le courant de fuite.

Par exemple, lesdits moyens 214 de détection d'une composante continue pourront comprendre un comparateur de tension comparant la tension Vout délivrée par le dispositif de détection 100 à une tension de référence. Si la tension Vout délivrée par le dispositif de détection 100 est supérieure à ladite tension de référence, les moyens de détection 214 indiquent la présence d'une composante continue dans l'élément conducteur 127.

Ledit système de détection est configuré pour détecter des courants avec un seuil prédéterminé Is dont la valeur peut aller jusqu'à 100 mA, notamment 30 mA, plus particulièrement 6 mA, ceci avec une erreur de l'ordre de, ou même inférieure à, 1 mA. Pour des intensités supérieures, le dispositif fonctionne à sa valeur maximale de mesure.

L'invention concerne aussi un système de protection électrique de la charge d'une batterie embarquée dans un véhicule, notamment automobile.

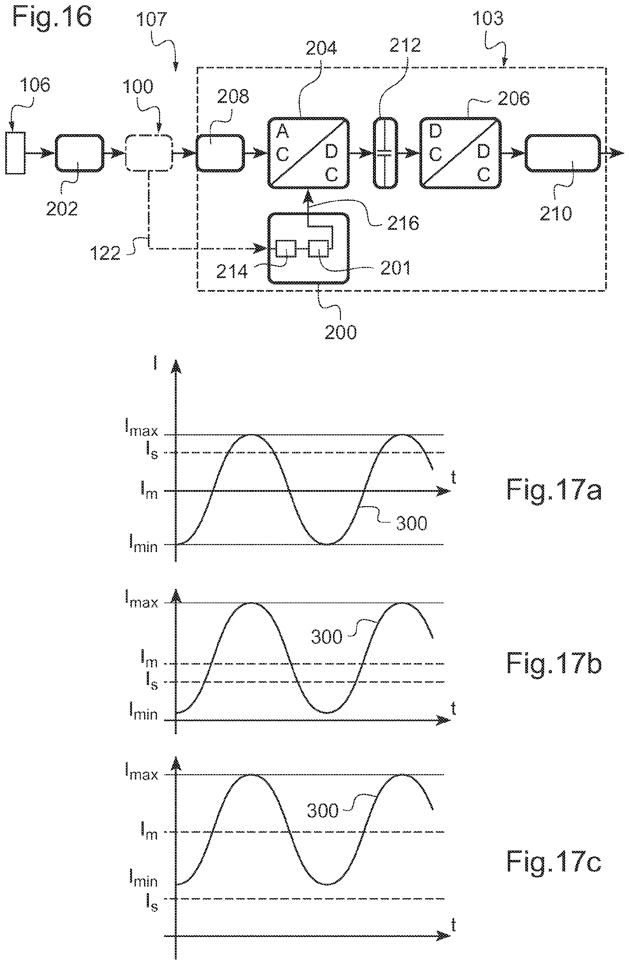

Le système de protection va être décrit en faisant référence à une application illustrée à la figure 16.

Ledit circuit électrique 103 est ici un chargeur de batterie et comprend en série un convertisseur alternatif/continu, notamment un redresseur 204, et un convertisseur continu / continu, notamment un élévateur de tension 206. Le redresseur 204 est relié à la ligne d'alimentation 107, notamment par un limiteur de courant d'appel 208. L'élévateur de tension 206 est reliée à la batterie à charger, notamment, par un filtre de sortie 210. Une capacité de découplage 212 pourra être insérée entre le redresseur 204 et l'élévateur de tension 206.

On remarque qu'un filtre d'entrée 202 pourra être inséré sur la ligne d'alimentation 107 en série avec le connecteur 106.

Le système de protection selon l'invention comprend un système de détection d'un courant de fuite tel que décrit plus haut et des moyens de contrôle 200 destinés à commander le circuit électrique 103.

Les moyens 214 de détection de composante continue délivrent un signal indiquant l'absence ou la présence d'une composante continue à une unité 201 délivrant des signaux adaptés au circuit électrique 103.

Lorsque le système de détection indique la présence d'une composante continue dans le courant de fuite, lesdits moyens de contrôle 200 du système de protection électrique permettent, par exemple, de faire fonctionner le convertisseur de tension ou redresseur 204, servant à la charge de la batterie, en mode dégradé. Plus précisément, lesdits moyens de contrôle 200 pourront être configurés pour transmette un ordre d'ouverture à tout ou partie des commutateurs, notamment des transistors, servant à la conversion de courant dans le redresseur 204.

Encore plus précisément, lesdits moyens de contrôle pourront être configurés pour réduire la fonction charge en modifiant la commande des commutateurs du convertisseur pour qu'ils arrêtent de faire de la correction de facteur de puissance. Autrement dit, on n'arrête pas la charge de la batterie, c'est-à-dire qu'on n'interrompt pas le courant délivré par le réseau, mais on ne la continue que partiellement, notamment dans la mesure nécessaire pour rester conforme aux contraintes imposées par le réseau.

On peut modifier de la sorte la charge de la batterie en éliminant la source probable du courant comportant une composante continue détectée par ledit système de détection, comme expliqué en relation avec les figures 7 et 8. Lesdits moyens de contrôle 200 peuvent même arrêter la charge de la batterie.

L'invention sera mieux comprise en faisant référence aux figures 17a à 17c qui représentent selon une courbe 300 les variations d'un courant alternatif au primaire 127 en fonction du temps. Les courants représentés sur ces figures ont une même amplitude ∆I=Imax-Imin.

A la figure 17a, le courant au primaire est de moyenne Im nulle et ne présente pas de composante continue. Le tore 128 est dans son état magnétique neutre et le dispositif de détection d'un courant de fuite 100 délivre un signal lui aussi de moyenne nulle. Les moyens de contrôle 200 du système de protection laissent la charge de la batterie s'effectuer de façon nominale.

A la figure 17b, le courant au primaire n'est plus de moyenne nulle. Cependant, bien que la moyenne Im du courant soit supérieure au seuil prédéterminé Is, la valeur minimale du courant Imin reste en dessous dudit seuil Is. Le tore 128 n'est plus dans son état magnétique neutre et le dispositif de détection de courant de fuite délivre lui aussi un signal de moyenne non nulle mais dont le minimum Imin passe suffisamment bas. On estime qu'une telle situation n'empêche pas le disjoncteur de l'installation domestique à laquelle le véhicule est raccordé de fonctionner. Les moyens de contrôle 200 laissent donc encore la charge de la batterie s'effectuer de façon nominale.

Par contre, à la figure 17c, la valeur minimale Imin du courant est passée au-dessus du seuil prédéterminé Is. On estime alors qu'une telle situation est dangereuse. Les moyens de contrôle 200 commandent alors un mode de charge dégradé de la batterie ou arrêtent la charge de la batterie.

Grâce au système de protection, le véhicule se suffit à lui-même pour protéger les personnes passant à proximité dudit véhicule ainsi que les occupants de l'habitation à laquelle le véhicule est branché pour la recharge de la batterie, ceci même en cas de présence d'une composante continue dans le courant circulant entre le véhicule et l'installation domestique. En effet, grâce auxdits moyens de mesure 124, embarqués dans le véhicule, on pourra détecter les configurations dangereuses et mettre en oeuvre les parades appropriées quel que soit le type de disjoncteur équipant ladite installation domestique.

Les moyens de contrôle 200 pourront être intégrés dans le circuit électrique 103 du véhicule. Ledit système de détection de composante continue et lesdits moyens de contrôle 200 du système de protection de charge de la batterie sont alors reliés, notamment, par l'intermédiaire du câble 122 reliant ledit circuit électrique 103 et ledit dispositif de détection d'un courant de fuite 100.

Lesdits moyens 214 de détection de composante continue peuvent être compris dans les moyens de contrôle 200. Lesdits moyens 214 de détection de composante continue sont alors reliés à la borne de sortie 170, 170' dudit dispositif de détection 100, par exemple par le câble 122 assurant la liaison entre le circuit électrique 103 du véhicule et ledit dispositif de détection 100. Alternativement, ces moyens 214 de détection de composante continue peuvent être inclus dans le dispositif 100 de mesure. Ceci permet d'alléger la charge de travail des moyens de contrôle 200. Ledit système de protection est alors configuré pour que ladite information de présence d'une composante continue dans le courant de fuite soit délivrée du dispositif de détection 100 vers les moyens de contrôle 200 qui déclencheront ou non le mode dégradé de charge de la batterie en fonction de ladite information de présence.

Si l'on se reporte de nouveau à la figure 9, l'invention concerne encore un système de mesure de l'impédance de terre de l'installation domestique 104 servant à la charge de la batterie de véhicule automobile 102. Ledit système de mesure comprend un dispositif 100 de détection d'un courant de fuite tel que décrit plus haut.

Ledit dispositif de détection 100 est alors configuré, par exemple, pour donner une mesure dans un conducteur neutre du câble d'alimentation 107 alimentant le circuit électrique 103 du véhicule.

Ledit système de mesure comprend des moyens de mesure de la tension entre ledit conducteur neutre et la terre de l'installation domestique 104. Grâce à la mesure de courant réalisée par le dispositif de détection 100, on peut alors déduire la valeur de l'impédance de terre, par la loi d'Ohm en faisant le rapport entre la tension mesurée et le courant (de Terre) mesuré.

Ledit système de mesure pourra aussi comprendre des moyens de mesure de la tension entre le neutre et le châssis du véhicule. L'impédance que l'on peut déduire par la loi d'Ohm comprend alors, en outre, l'impédance du châssis.

Ledit système de mesure de l'impédance de terre pourra encore comprendre une alimentation apte à provoquer un courant de test présentant une composante continue dans ledit câble d'alimentation 108.

Bien entendu, l'invention ne se limite pas aux exemples décrits.

En particulier, l'invention s'applique à un moteur ayant plusieurs phases.

En outre, l'invention a été décrite avec des moyens de mesure 124 mesurant un courant circulant dans un élément conducteur 127. Cependant, les moyens 124 peuvent mesurer un courant résultant. Dans ce cas, le tore 128 est traversé par plusieurs éléments conducteurs qui produisent ce courant résultant.

En particulier, le circuit électrique 103 est un onduleur/chargeur à pont en H, par exemple tel que le dispositif divulgué dans les demandes de brevet Français FR2938711 ou FR2944391 de la demanderesse.

La figure 17c illustre un exemple dans lequel le critère permettant de déterminer si le courant au primaire (c'est-à-dire issu du circuit 103) a une composante continue qui rend défaillant un disjoncteur différentiel 11 d'une habitation consiste à déterminer lorsque la valeur minimale Imin du courant au primaire est supérieure à un seuil prédéterminé Is. Cependant, il existe d'autres critères. Par exemple, la présence d'un courant continu qui rend défaillant le disjoncteur différentiel 11 pourrait être mise en évidence lorsque le rapport entre une composante continue du courant issu du circuit 103 et une composante alternative de ce même courant est supérieur à un seuil prédéterminé.

## Revendications

1. Dispositif (100) de détection d'un courant de fuite comprenant des moyens (124) de mesure d'un courant issu d'un circuit électrique (103) d'un véhicule (102), notamment véhicule automobile, ledit dispositif de détection (100) étant configuré pour être embarqué dans ledit véhicule (102) et étant tel que les moyens de mesure (124) comprennent :

   - un tore magnétique (128) configuré pour être traversé par un ou plusieurs éléments conducteurs (127) parcourus par ledit courant issu du circuit électrique (103), ledit ou lesdits éléments conducteurs (127) formant un enroulement primaire ;
   - un enroulement secondaire (130), enroulé autour dudit tore (128), pour générer un flux magnétique à partir d'un courant de référence ;
   - un oscillateur (132) pour générer le courant de référence à travers l'enroulement secondaire (130), le courant de référence étant configuré pour faire saturer ledit tore (128) ;

   où le dispositif de détection est **caractérisé en ce que** la valeur du courant de l'enroulement primaire (127) est obtenue à partir de la valeur moyenne du courant au secondaire (130) sur une période d'oscillation parcourant un cycle complet de magnétisation et de démagnétisation du tore (128) et dans lequel les moyens (124) de mesure comprennent :

   - un module intégrateur-comparateur (150) configuré pour délivrer un courant, dit image du courant au primaire, qui est fonction du courant issu du circuit (103), et
   - des moyens (130, 152) pour compenser le flux généré par le courant issu du circuit électrique (103) à partir du courant délivré par ledit module (150).

2. Dispositif selon la revendication 1, dans lequel les moyens de mesure (124) comprennent en outre des moyens (193, 195, 196) pour sécuriser le fonctionnement de l'oscillateur (132).

3. Dispositif selon la revendication 1, dans lequel les moyens de compensation de flux comprennent un troisième enroulement (152) enroulé autour dudit tore (128), et dans lequel une sortie dudit module intégrateur-comparateur (150) est reliée audit troisième enroulement (152) de façon à ce que ledit troisième enroulement (152) soit parcouru par ledit courant image du courant au primaire.

4. Dispositif selon la revendication 1, dans lequel les moyens de compensation de flux sont formés par ledit enroulement secondaire (130) et dans lequel une sortie dudit module intégrateur-comparateur (150) est reliée audit enroulement secondaire (130) de façon à ce que ledit enroulement secondaire (130) soit parcouru par ledit courant image du courant au primaire.

5. Dispositif selon la revendication 4, dans lequel lesdits moyens de mesure (124) comprennent une résistance (135), dite de paramétrage, ayant une première borne reliée à l'enroulement secondaire (130) et à l'oscillateur (132), et une seconde borne reliée à une borne de sortie (170) du dispositif et au module intégrateur-comparateur (150) de façon à ajuster les caractéristiques de sortie du dispositif et les caractéristiques de l'oscillateur (132).

6. Dispositif selon la revendication 4, dans lequel lesdits moyens de mesure (124) comprennent une résistance (169), dite d'ajustement, ayant une première borne reliée à l'enroulement secondaire (130) et à l'oscillateur (132) et une seconde borne reliée à une masse dudit dispositif (100) de façon à ajuster les caractéristiques de l'oscillateur (132).

7. Dispositif selon la revendication 5 ou 6, dans lequel lesdits moyens de mesure (124) comprennent une résistance (168), dite de mesure, ayant une première borne reliée à l'enroulement secondaire (130), et une seconde borne reliée à une borne de sortie (170) du dispositif et au module intégrateur-comparateur (150) de façon à ajuster les caractéristiques de sortie du dispositif.

8. Dispositif selon l'une des revendications précédentes, dans lequel les moyens de mesure (124) comprennent des moyens de filtrage (182) dudit courant image du courant au primaire permettant d'obtenir un signal présentant un profil sensiblement identique à celui du courant issu du circuit électrique (103).

9. Dispositif selon la revendication 8, dans lequel les moyens de mesure (124) comprennent des moyens (194) pour ajuster la plage de tension en sortie du module de filtrage (182).

10. Dispositif selon l'une quelconque des revendications précédentes comprenant un générateur (183) de masse fictive (184), lesdits moyens de mesure (124) étant reliés à ladite masse fictive (184).

11. Dispositif selon la revendication 10, dans lequel ledit oscillateur (132), et/ou ledit générateur de masse fictive (184), et/ou ledit module intégrateur-comparateur (150) comprennent au moins un amplificateur opérationnel (156, 162, 185) respectif.

12. Dispositif selon la revendication 11, dans lequel ledit amplificateur opérationnel (156, 162, 185) est tel que son temps de transition est inférieur à 50 ns.

13. Dispositif selon l'une des revendications 11 ou 12, dans lequel ledit amplificateur opérationnel (156, 162, 185) est relié en sortie à un amplificateur de courant (172, 178, 186).

14. Système de protection électrique de la charge d'une batterie embarquée dans un véhicule, notamment automobile, comprenant un dispositif de détection d'un courant de fuite (100) selon l'une quelconque des revendications précédentes.

15. Système de protection électrique selon la revendication 14 comprenant des moyens (200) de contrôle permettant de faire fonctionner en mode dégradé un circuit (103) servant à la charge de ladite batterie.

16. Système de mesure d'une impédance de terre (114) d'une installation domestique (104) servant à la charge d'une batterie de véhicule automobile, ledit système de mesure comprenant un dispositif de détection d'un courant de fuite (100) selon l'une quelconque des revendications 1 à 13.

17. Système de charge d'une batterie embarquée dans un véhicule, ledit système de charge comprenant un système de protection électrique selon l'une quelconque des revendications 14 ou 15 et/ou un système de mesure d'impédance de terre selon la revendication 16.

18. Procédé de charge d'une batterie, notamment d'un véhicule, comprenant :

- la fourniture d'un système de charge selon la revendication 17 ;
- la charge de la batterie avec une correction de facteur de puissance par l'intermédiaire dudit système de charge ;
- la poursuite de la charge sans la correction de facteur de puissance lorsqu'un rapport entre une composante continue du courant de fuite et une composante alternative de ce courant de fuite est supérieur à un seuil prédéterminé.

**Patentansprüche**

1. Vorrichtung (100) zur Detektion eines Leckstroms, die Mittel (124) zum Messen eines aus einer elektrischen Schaltung (103) eines Fahrzeugs (102), insbesondere eines Kraftfahrzeugs, stammenden Stroms beinhaltet, wobei die Detektionsvorrichtung (100) dazu konfiguriert ist, in dem Fahrzeug (102) integriert zu sein, und derart ist, dass die Messmittel (124) Folgendes beinhalten:

- einen Magnettorus (128), der dazu konfiguriert ist, dass ein oder mehrere leitende Elemente (127), durch die der aus der elektrischen Schaltung (103) stammende Strom fließt, durch ihn hindurchgehen, wobei das oder die leitenden Elemente (127) eine Primärwicklung bilden;
- eine Sekundärwicklung (130), die um den Torus (128) gewickelt ist, um anhand eines Referenzstroms einen Magnetfluss zu erzeugen;
- einen Oszillator (132), um den Referenzstrom durch die Sekundärwicklung (130) zu erzeugen, wobei der Referenzstrom dazu konfiguriert ist, den Torus (128) zu sättigen;

wobei die Detektionsvorrichtung **dadurch gekennzeichnet ist, dass** der Wert des Stroms der Primärwicklung (127) anhand des Mittelwerts des Stroms in der Sekundärwicklung (130) über eine Oszillationsperiode, die einen kompletten Magnetisierungs- und Demagnetisierungszyklus des Torus (128) durchläuft, erhalten wird, und wobei die Messmittel (124) Folgendes beinhalten:

- ein Integrator-Komparator-Modul (150), das dazu konfiguriert ist, einen Strom, als Abbildungsstrom des Stroms in der Primärwicklung bezeichnet, zu liefern, der eine Funktion des aus der Schaltung (103) stammenden Stroms ist,
- Mittel (130, 152) zum Kompensieren des Flusses, der durch den aus der elektrischen Schaltung (103) stammenden Strom erzeugt wird, anhand des durch das Modul (150) gelieferten Stroms.

2. Vorrichtung nach Anspruch 1, wobei die Messmittel (124) ferner Mittel (193, 195, 196) zum Absichern des Betriebs des Oszillators (132) beinhalten.

3. Vorrichtung nach Anspruch 1, wobei die Flusskompensationsmittel eine dritte Wicklung (152) beinhalten, die um den Torus (128) gewickelt ist, und wobei ein Ausgang des Integrator-Komparator-Moduls (150) mit der dritten Wicklung (152) verbunden ist, sodass die dritte Wicklung (152) von dem Abbildungsstrom des Stroms in der Primärwicklung durchflossen wird.

**4.** Vorrichtung nach Anspruch 1, wobei die Flusskompensationsmittel durch die Sekundärwicklung (130) gebildet sind und wobei ein Ausgang des Integrator-Komparator-Moduls (150) mit der Sekundärwicklung (130) verbunden ist, sodass die Sekundärwicklung (130) von dem Abbildungsstrom des Stroms in der Primärwicklung durchflossen wird.

**5.** Vorrichtung nach Anspruch 4, wobei die Messmittel (124) einen Widerstand (135), als Parametrierwiderstand bezeichnet, beinhalten, der einen ersten Anschluss, der mit der Sekundärwicklung (130) und dem Oszillator (132) verbunden ist, und einen zweiten Anschluss, der mit einem Ausgangsanschluss (170) der Vorrichtung und dem Integrator-Komparator-Modul (150) verbunden ist, aufweist, um die Ausgangseigenschaften der Vorrichtung und die Eigenschaften des Oszillators (132) einzustellen.

**6.** Vorrichtung nach Anspruch 4, wobei die Messmittel (124) einen Widerstand (169), als Einstellwiderstand bezeichnet, beinhalten, der einen ersten Anschluss, der mit der Sekundärwicklung (130) und dem Oszillator (132) verbunden ist, und einen zweiten Anschluss, der mit einer Masse der Vorrichtung (100) verbunden ist, aufweist, um die Eigenschaften des Oszillators (132) einzustellen.

**7.** Vorrichtung nach Anspruch oder 5 oder 6, wobei die Messmittel (124) einen Widerstand (168), als Messwiderstand bezeichnet, beinhalten, der einen ersten Anschluss, der mit der Sekundärwicklung (130) verbunden ist, und einen zweiten Anschluss, der mit einem Ausgangsanschluss (170) der Vorrichtung und dem Integrator-Komparator-Modul (150) verbunden ist, aufweist, um die Ausgangseigenschaften der Vorrichtung einzustellen.

**8.** Vorrichtung nach einem der vorhergehenden Ansprüche, wobei die Messmittel (124) Mittel zum Filtern (182) des Abbildungsstroms des Stroms in der Primärwicklung beinhalten, die es ermöglichen, ein Signal zu erhalten, das ein Profil aufweist, das zu dem des aus der elektrischen Schaltung (103) stammenden Stroms im Wesentlichen identisch ist.

**9.** Vorrichtung nach Anspruch 8, wobei die Messmittel (124) Mittel (194) zum Einstellen des Spannungsbereichs am Ausgang des Filtermoduls (182) beinhalten.

**10.** Vorrichtung nach einem beliebigen der vorhergehenden Ansprüche, die einen Generator (183) mit fiktiver Masse (184) beinhaltet, wobei die Messmittel (124) mit der fiktiven Masse (184) verbunden sind.

**11.** Vorrichtung nach Anspruch 10, wobei der Oszillator (132) und/oder der Generator mit fiktiver Masse (184) und/oder das Integrator-Komparator-Modul (150) mindestens einen jeweiligen Operationsverstärker (156, 162, 185) beinhalten.

**12.** Vorrichtung nach Anspruch 11, wobei der Operationsverstärker (156, 162, 185) derart ist, dass seine Transitionszeit kleiner als 50 ns ist.

**13.** Vorrichtung nach einem der Ansprüche 11 oder 12, wobei der Operationsverstärker (156, 162, 185) am Ausgang mit einem Stromverstärker (172, 178, 186) verbunden ist.

**14.** System zum elektrischen Schutz des Ladens einer in ein Fahrzeug, insbesondere ein Kraftfahrzeug, integrierten Batterie, das eine Vorrichtung zur Detektion eines Leckstroms (100) nach einem beliebigen der vorhergehenden Ansprüche beinhaltet.

**15.** Elektrisches Schutzsystem nach Anspruch 14, das Steuermittel (200) beinhaltet, die es ermöglichen, eine Schaltung (103), die zum Laden der Batterie dient, in einem Notmodus zu betreiben.

**16.** System zum Messen einer Erdimpedanz (114) einer Hausinstallation (104), die zum Laden einer Kraftfahrzeugbatterie dient, wobei das Messsystem eine Vorrichtung zur Detektion eines Leckstroms (100) nach einem beliebigen der vorhergehenden Ansprüche 1 bis 13 beinhaltet.

**17.** System zum Laden einer in ein Fahrzeug integrierten Batterie, wobei das Ladesystem ein elektrisches Schutzsystem nach einem beliebigen der Ansprüche 14 oder 15 und/oder ein System zum Messen einer Erdimpedanz nach Anspruch 16 beinhaltet.

**18.** Verfahren zum Laden einer Batterie, insbesondere eines Fahrzeugs, das Folgendes beinhaltet:

- Bereitstellen eines Ladesystems nach Anspruch 17;
- Laden der Batterie mit einer Leistungsfaktorkorrektur mit Hilfe des Ladesystems;
- Fortsetzen des Ladens ohne die Leistungsfaktorkorrektur, wenn ein Verhältnis zwischen einem Gleichstromanteil des Leckstroms und einem Wechselstromanteil dieses Leckstroms größer als ein vorbestimmter Schwellenwert ist.

**Claims**

**1.** Device (100) for detecting a leakage current comprising means (124) for measuring a current from an electric circuit (103) of a vehicle (102), in particular a motor vehicle, said detection device (100) being configured to be installed in said vehicle (102) and being such that the measuring means (124) comprise:

- a magnetic core (128) configured to be passed through by one or more conductive elements (127) through which said current from the electric circuit (103) is passed, said conductive element or said conductive elements (127) forming a primary winding;
- a secondary winding (130), wound around said core (128), for generating a magnetic flux on the basis of a reference current;
- an oscillator (132) for generating the reference current through the secondary winding (130), the reference current being configured to saturate said core (128) ;

the detection device being **characterized in that** the value of the current of the primary winding (127) is obtained on the basis of the mean value of the current at the secondary winding (130) over a period of oscillation covering a complete core (128) magnetization and demagnetization cycle and **in that** the measuring means (124) comprise:

- an integrator/comparator module (150) configured to deliver a current, referred to as the image of the current at the primary winding, which is dependent on the current from the circuit (103), and
- means (130, 152) for compensating for the flux generated by the current from the electric circuit (103) on the basis of the current delivered by said module (150) .

2. Device according to Claim 1, wherein the measuring means (124) further comprise means (193, 195, 196) for protecting the functioning of the oscillator (132).

3. Device according to Claim 1, wherein the flux compensation means comprise a third winding (152) wound around said core (128), and wherein an output of said integrator/comparator module (150) is connected to said third winding (152) such that said third winding (152) is passed through by said current that is the image of the current at the primary winding.

4. Device according to Claim 1, wherein the flux compensation means are formed by said secondary winding (130), and wherein an output of said integrator/comparator module (150) is connected to said secondary winding (130) such that said secondary winding (130) is passed through by said current that is the image of the current at the primary winding.

5. Device according to Claim 4, wherein said measuring means (124) comprise a resistor (135), referred to as a parameterizing resistor, having a first terminal connected to the secondary winding (130) and to the oscillator (132) and a second terminal connected to an output terminal (170) of the device and to the integrator/comparator module (150) so as to adjust the output characteristics of the device and the characteristics of the oscillator (132).

6. Device according to Claim 4, wherein said measuring means (124) comprise a resistor (169), referred to as an adjusting resistor, having a first terminal connected to the secondary winding (130) and to the oscillator (132) and a second terminal connected to a ground of said device (100) so as to adjust the characteristics of the oscillator (132).

7. Device according to Claim 5 or 6, wherein said measuring means (124) comprise a resistor (168), referred to as a measuring resistor, having a first terminal connected to the secondary winding (130) and a second terminal connected to an output terminal (170) of the device and to the integrator/comparator module (150) so as to adjust the output characteristics of the device.

8. Device according to one of the preceding claims, wherein the measuring means (124) comprise means (182) for filtering said current that is the image of the current at the primary winding, thus making it possible to obtain a signal having a profile substantially identical to that of the current from the electric circuit (103).

9. Device according to Claim 8, wherein the measuring means (124) comprise means (194) for adjusting the voltage range at the output of the filter module (182).

10. Device according to any one of the preceding claims, comprising a generator (183) of fictitious ground (184), said measuring means (124) being connected to said fictitious ground (184).

11. Device according to Claim 10, wherein said oscillator (132) and/or said generator of fictitious ground (184) and/or said integrator/comparator module (150) comprise at least one respective operational amplifier (156, 162, 185).

12. Device according to Claim 11, wherein said operational amplifier (156, 162, 185) is such that its transition time is less than 50 ns.

13. Device according to Claim 11 or 12, wherein said operational amplifier (156, 162, 185) is connected at the output to a current amplifier (172, 178, 186).

14. Electric system for protecting the charging of a battery installed in a vehicle, in particular a motor vehicle, comprising a device for detecting a leakage current (100) according to any one of the preceding claims.

15. Electric protection system according to Claim 14, comprising control means (200) making it possible to make a circuit (103) serving to charge said battery operate in a degraded mode.

16. System for measuring a ground impedance (114) of a domestic installation (104) serving to charge a battery of a motor vehicle, said measuring system comprising a device for detecting a leakage current (100) according to any one of Claims 1 to 13.

17. System for charging a battery installed in a vehicle, said charging system comprising an electric protection system according to either one of Claims 14 and 15 and/or a system for measuring ground impedance according to Claim 16.

18. Method for charging a battery, in particular a vehicle battery, comprising:

> - the provision of a charging system according to Claim 17;
> - the charging of the battery with a power factor correction by means of said charging system;
> - the continuance of the charging without the power factor correction when a ratio between a continuous component of the leakage current and an alternating component of this leakage current is greater than a predetermined threshold.

# Fig.1

# Fig.2

Fig.3

Fig.4

Fig.5

Fig.6

Fig.7

Fig.8

Fig.9

Fig.10

Fig.18

Fig.11

Fig.12

# Fig.13

# Fig.14

Fig.15

EP 2 820 733 B1

Fig.16

Fig.17a

Fig.17b

Fig.17c

Fig.19

EP 2 820 733 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2005114805 A2
- FR 2919068 A1
- FR 2938711
- FR 2944391